# EUROPEAN PATENT APPLICATION

(11) **EP 1 806 440 A2**
(43) Date of publication of application: **11.07.2007**
(21) Application number: 07250032.5
(22) Date of filing: 04.01.2007
(51) Int. Cl.: C30B 29/40, C30B 23/00

(54) **Manufacturing method of aluminum nitride single crystal and aluminum nitride single crystal**

(30) Priority: 10.01.2006 JP 2006002744; 16.03.2006 JP 2006072933; 14.08.2006 JP 2006220981
(71) Applicant: NGK INSULATORS, LTD., Nagoya-City, Aichi Pref. 467-8530 (JP)
(72) Inventor: Kobayashi, Yoshimasa, c/o Legal Affairs and Int., Mizuho-ku Nagoya City Aichi-ken 467-8530 (JP); Yamada, Naohito, c/oLegal Affairs and Intellectual, Mizuho-ku Nagoya City Aichi-ken 467-8530 (JP)
(74) Representative: Paget, Hugh Charles Edward

(57) **Abstract**

A seed crystal is formed of a rod-like aluminum nitride single crystal whose length direction is oriented to the c-axis direction. Exposed surface on the side portion thereof on which an aluminum nitride material is grown into a crystal has an inclination of 90° relative to a {0001} surface. With this configuration, an aluminum nitride single crystal with excellent crystallinity can be manufactured.

## Description

### CROSS REFERENCE TO RELATED APPLICATION

This application is based upon and claims the benefit of priority from a Japanese Patent Application No. TOKUGAN 2006-002744, filed on January 10, 2006, a Japanese Patent Application No. TOKUGAN 2006-072933, filed on March 16, 2006, and a Japanese Patent Application No. TOKUGAN 2006-220981, filed on August 14, 2006; the entire contents of which are incorporated herein by reference.

### BACKGROUND OF THE INVENTION

### 1. Field of the Invention

The present invention relates to a manufacturing method of an aluminum nitride single crystal and an aluminum nitride single crystal suitable for use in substrate materials for a semiconductor light emitting device and a semiconductor device desirably having high heat-radiation characteristics, a heat sink, electric/electronic components such as a semiconductor, optical components, electric device components, and OA device components.

### 2. Description of the Related Art

Conventionally, as a manufacturing method of aluminum nitride (AlN) single crystal, various methods have been proposed including a nitriding method, flux method, chemical transportation method, sublimation method and chemical vapor deposition method. Generally, as disclosed in Japanese Patent Application Laid-open No. 2004-284869, an aluminum nitride single crystal is manufactured by growing a crystal of aluminum nitride on a crystal growth substrate (seed crystal), which is a hexagonal crystal whose exposed surfaces are oriented to a c-axis direction.

According to a conventional manufacturing method, however, since a crystal is grown in the c-axis direction, a defect such as screw dislocation, which is oriented in the c-axis direction and contained in the crystal growth substrate, propagates in the grown crystal. As a result, it is difficult to manufacture an aluminum nitride single crystal having more excellent crystallinity than that of a crystal growth substrate.

The present invention has been achieved to solve the aforementionedproblems, and an object of the invention is to provide a manufacturing method of an aluminum nitride single crystal with excellent crystallinity.

### SUMMARY OF THE INVENTION

In the manufacturing method of an aluminum nitride single crystal according to the present invention, an aluminum nitride single crystal is manufactured by growing an aluminum nitride crystal on an exposed surface of a crystal growth substrate which has an inclination of 90° relative to a {0001} plane.

### BRIEF DESCRIPTION OF THE DRAWINGS

Exemplary embodiments of the invention will become more fully apparent from the following description and appended claims, taken in conjunction with the accompanying drawings. Understanding that these drawings depict only exemplary embodiments and are, therefore, not to be considered limiting of the invention' s scope, the exemplary embodiments of the invention will be described with additional specificity and detail through use of the accompanying drawings in which:
Fig. 1 is a schematic diagram showing a configuration of an apparatus for manufacturing a single crystal according to an embodiment of the present invention;
Fig. 2 is a microscope photograph showing a shape of the tip portion of a seed crystal according to the embodiment of the present invention;
Fig. 3 is an explanatory diagram of plane direction of an aluminum nitride crystal;
Fig. 4 is a schematic diagram showing a configuration of an apparatus for manufacturing a single crystal which is an application of the embodiment of the present invention;
Fig. 5 shows measurement results of the half-value width of an X-ray rocking curve with respect to aluminum nitride single crystals manufactured by manufacturing methods of Examples 1 to 6 and Comparative Examples 1 and 2;
Fig. 6 shows evaluation results of chemical analysis, lattice constant, volume resistivity and thermal conductivity with respect to aluminum nitride single crystals manufactured by the methods of Examples 1 to 3 and Comparative Examples 1 and 2; and
Fig. 7 is a graph showing light transmittance of an aluminum nitride single crystal according to the embodiment of the present invention.

### DETAILED DESCRIPTION OF THE PREFERRED EMBODIMENTS

The present inventors have made strenuous researches, and consequently found that defects such as screw dislocation contained in a seed crystal and oriented in the c-axis direction canbe prevented from propagating through the crystal by growing a crystal of aluminum nitride onto a seed crystal whose exposed surface has an inclination of 90° relative to the {0001} plane, more preferably, whose exposed surface is a {10-10} plane, thereby manufacturing an aluminum nitride single crystal with excellent crystallinity. The inventors also found that the same effect can be obtained even if a crystal is grown onto the exposed surface which is having an inclination in the range of 0° to 10° relative to the {10-10} plane in an arbitral direction.

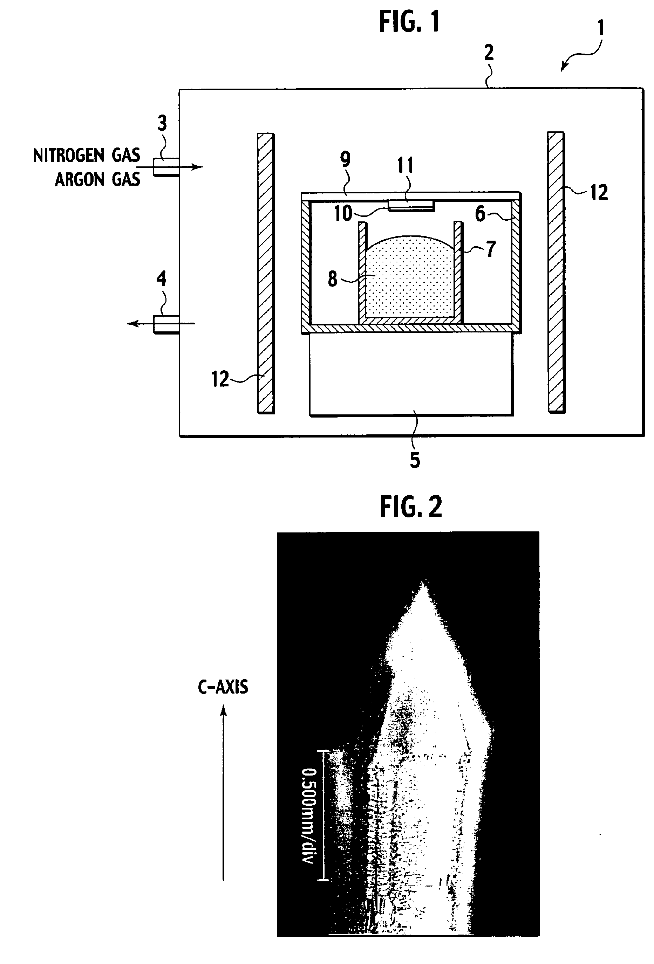

The present invention has been achieved based on the aforementioned findings, and according to an embodiment of the invention, a single crystal manufacturing apparatus 1 is provided. The single crystal manufacturing apparatus 1 comprises a furnace 2, a gas supply port 3 for supplying an inert gas such as nitrogen gas and argon gas into the furnace 2, a gas exhaustion port 4 for exhausting the gas within the furnace 2, a main body 6 having an opening port and mounted on a mounting table 5 in the furnace 2, a container 7 housed in the main body 6, a raw material 8 formed of a compound or a mixture constituted of Al, O, and N and housed in the container 7, a cover 9 closing the opening portion of the main body 6, a storage 11 provided onto the rear surface of the cover 9 for storing a seed crystal 10, and a heater 12 for heating inside the furnace 2, as shown in Fig. 1.

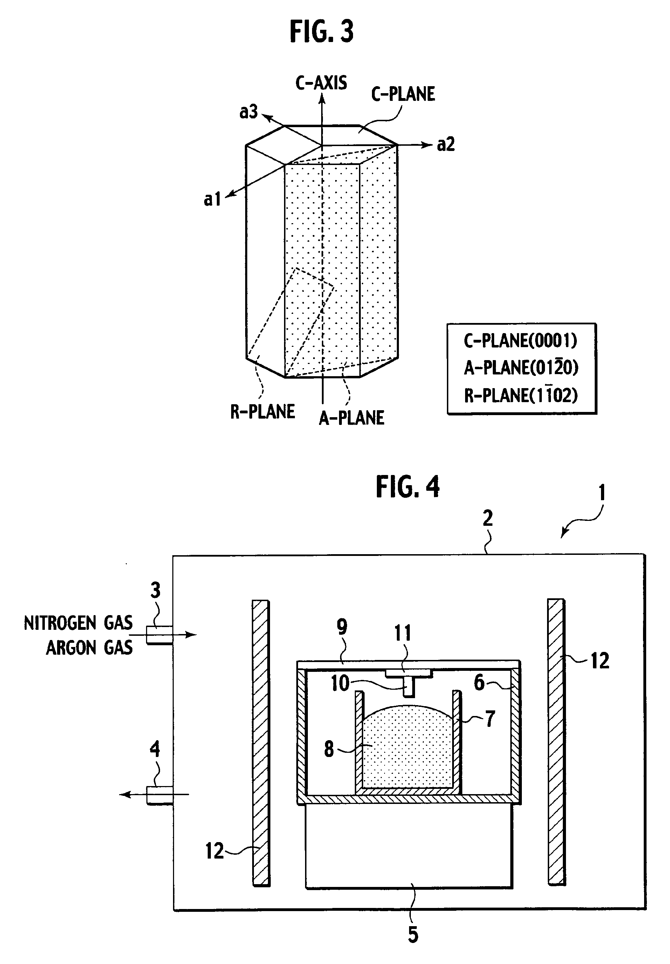

In the single crystal producing apparatus 1, the seed crystal 10 is formed of a rod-like aluminum nitride single crystal whose length direction is oriented to the c-axis direction and whose sectional shape is a hexagonal, meaning that six surfaces are exposed on the side portion of the crystal at which an aluminum nitride crystal is grown (see Fig. 2). The exposed surface (A plane in Fig. 3) on the side portion has an inclination of 90° relative to the {0001} plane. In the single crystal manufacturing apparatus 1 having such a configuration, a gas mainly serving as an aluminum source of aluminum nitride is allowed to generate from the raw material 8 by raising the temperature inside the furnace 2 by means of the heater 12, and the generated gas is reacted with nitrogen in the atmosphere, thereby growing an aluminumnitride single crystal on the exposed surface of the seed crystal 10.

At this time, the aluminum nitride single crystal is grown under a manufacturing condition where a ratio of the growth rate of aluminum nitride in an a-axis direction relative to that in the c-axis direction is 1 or more under a manufacturing condition where the growth rate in the a-axis direction of aluminum nitride falls within the range of 100 µm or more to 2000 µm or less. As a result, an aluminum nitride single crystal excellent in productivity and improved in crystallinity can be manufactured. This was also found by the present inventors.

Furthermore, as described above, since six surfaces each having an inclination of 90° relative to the {0001} plane are exposed on the side portion of the seed crystal 10 upon which the raw material 8 is grown into a crystal, the seed crystal 10 may be arranged such that the surface of the raw material 8 is perpendicular to two exposed surfaces or more, preferably all of the six exposed surfaces, as shown in Fig. 4, to grow an aluminum nitride single crystal simultaneously on the two exposed surfaces or more, preferably six exposed surfaces. According to such a manufacturing method, the growth rate of an aluminum nitride single crystal can be greatly increased.

Hereinafter, examples of an aluminum nitride single crystal manufactured by the single crystal manufacturing apparatus 1 will be explained.

### [Example 1]

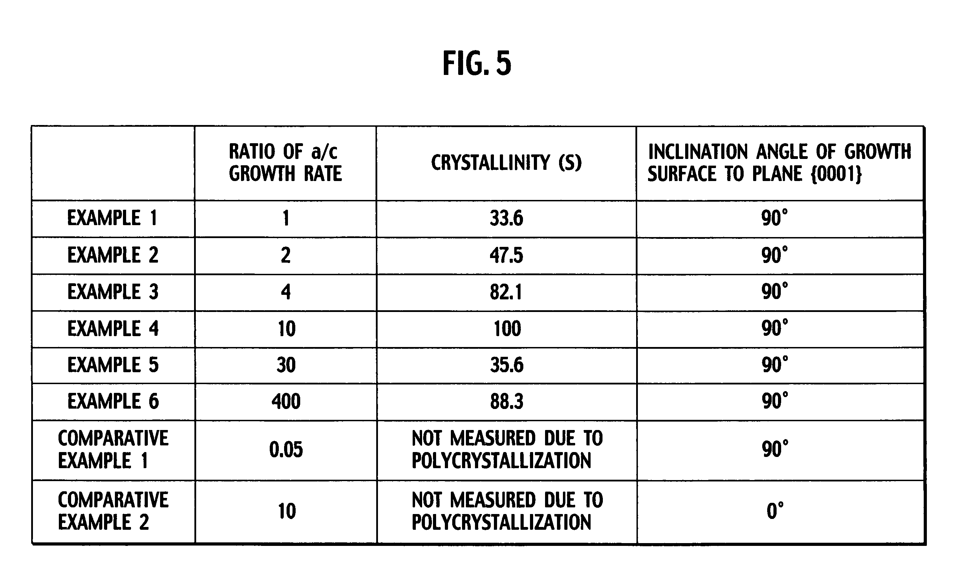

In Example 1, an aluminum nitride single crystal was grown on a seed crystal 10 whose exposed surface had an inclination of 90° relative to the {0001} plane such that a ratio of the growth rate in the a-axis direction relative to that in the c-axis direction of aluminum nitride was 1. When the X-ray rocking curve of the aluminum nitride single crystal thus manufactured was measured with respect to the half-value width, the half-value width was 33.6 s. The results are shown in Fig. 5. Note that a ratio of the growth rate in the a-axis direction relative to that in the c-axis direction of the aluminum nitride was computationally obtained based on a shape and a crystal orientation of an aluminum nitride crystal grown by spontaneous nucleation on the surface of a jig in the periphery of the seed crystal 10.

### [Example 2]

In Example 2, an aluminum nitride single crystal was grown on the seed crystal 10 whose exposed surface had an inclination of 90° relative to the {0001} plane such that a ratio of the growth rate in the a-axis direction relative to that in the c-axis direction of aluminum nitride was 2. When the X-ray rocking curve of the aluminum nitride single crystal thus manufactured was measured with respect to the half-value width, the half-value width was 47.5 s. The results are shown in Fig. 5.

### [Example 3]

In Example 3, an aluminum nitride single crystal was grown on the seed crystal 10 whose exposed surface had an inclination of 90° relative to the {0001} plane such that a ratio of the growth rate in the a-axis direction relative to that in the c-axis direction of aluminum nitride was 4. When the X-ray rocking curve of the aluminum nitride single crystal thus manufactured was measured with respect to the half-value width, the half-value width was 82.1 s. The results are shown in Fig. 5.

### [Example 4]

In Example 4, an aluminum nitride single crystal was grown on the seed crystal 10 whose exposed surface had an inclination of 90° relative to the {0001} plane such that a ratio of the growth rate in the a-axis direction relative to that in the c-axis direction of aluminum nitride was 10. When the X-ray rocking curve of the aluminum nitride single crystal thus manufactured was measured with respect to a half-value width, the half-value width was 100 s. The results are shown in Fig. 5.

### [Example 5]

In Example 5, an aluminum nitride single crystal was grown on the seed crystal 10 whose exposed surface had an inclination of 90° relative to the {0001} plane such that a ratio of the growth rate in the a-axis direction relative to that in the c-axis direction of aluminum nitride was 30. When the X-ray rocking curve of the aluminum nitride single crystal thus manufactured was measured with respect to the half-value width, the half-value width was 35.6 s. The results are shown in Fig. 5.

### [Example 6]

In Example 6, an aluminum nitride single crystal was grown on the seed crystal 10 whose exposed surface had an inclination of 90° relative to the {0001} plane such that a ratio of the growth rate in the a-axis direction relative to that in the c-axis direction of aluminum nitride was 400. When the X-ray rocking curve of the aluminum nitride single crystal thus manufactured was measured with respect to the half-value width, the half-value width was 88.3 s. The results are shown in Fig. 5.

### [Comparative Example 1]

In Comparative Example 1, an aluminum nitride single crystal was grown on the seed crystal 10 whose exposed surface had an inclination of 90° relative to the {0001} plane such that a ratio of the growth rate in the a-axis direction to that in the c-axis direction of the aluminum nitride was 0.05. Since the aluminum nitride crystal manufactured was polycrystalline, the half-value width of the X-ray rocking curve was not obtained. The results are shown in Fig. 5.

### [Comparative Example 2]

In Comparative Example 2, an aluminum nitride single crystal was grown on the seed crystal 10 whose exposed surface was the {0001} plane such that a ratio of the growth rate in the a-axis direction to that in the c-axis direction of the aluminum nitride was 10. Since the aluminum nitride crystal manufactured was polycrystalline, the half-value width of the X-ray rocking curve was not obtained. The results are shown in Fig. 5.

### [Evaluation]

When the manufacturing method of Example 4 was compared to that of Comparative Example 2, it is found that even though the ratio of the growth rate in the a-axis direction to that in the c-axis direction of the aluminum nitride are the same, the manufacturing method of Example 4 is superior in manufacturing an aluminum nitride single crystal with excellent crystallinity, as is apparent from the half-value width of the X-ray rocking curve. From this, it is demonstrated that an aluminum nitride single crystal with excellent crystallinity can be obtained by growing an aluminum nitride single crystal on the seed crystal 10 whose exposed surface has an inclination of 90° relative to the {0001} plane.

Furthermore, when the manufacturing methods of Examples 1 to 6 are compared to that of Comparative Example 1, it is found that even though the same seed crystal 10 is used, the manufacturing methods of Examples 1 to 6 are superior in manufacturing an aluminum nitride single crystal with excellent crystallinity. From this, it is demonstrated that an aluminum nitride single crystal with excellent crystallinity can be manufactured by setting the ratio of the growth rate in the a-axis direction relative to that in the c-axis direction of the aluminum nitride at 1 or more.

### [Characteristics of aluminum nitride single crystal]

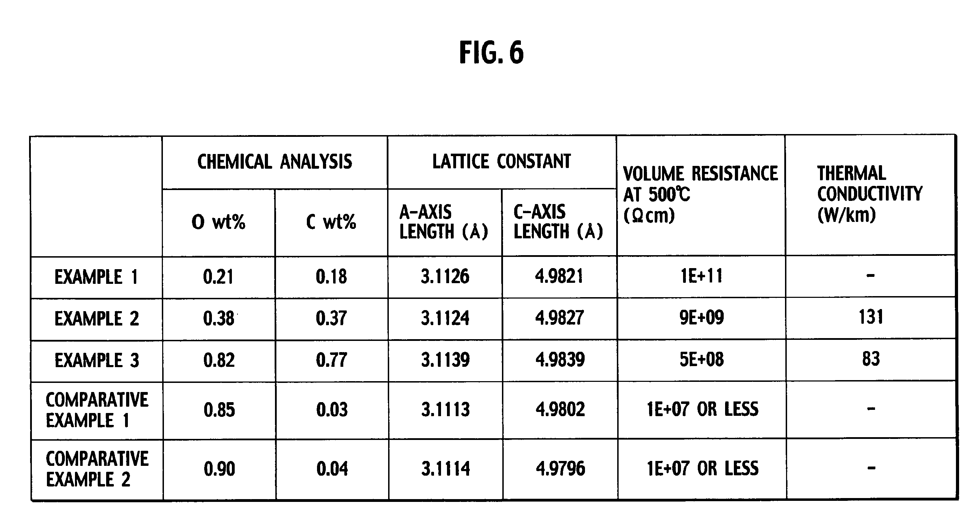

Finally, aluminum nitride single crystals produced by the manufacturing methods of Examples 1 to 3 and Comparative Examples 1 and 2 were evaluated for chemical analysis, lattice constant, volume resistivity and thermal conductivity. The results are shown in Fig. 6.

As is apparent from Fig. 6, it was found that the aluminum nitride single crystals manufactured by the manufacturing methods of Examples 1 to 3 contain carbon in an amount of 0.10 wt% or more to 1.0 wt% or less and oxygen in an amount of 0.10 wt% or more to 1.0 wt% or less.

It was also found that the aluminum nitride single crystals manufactured by the manufacturing methods of Examples 1 to 3 have lattice constants in the a-axis direction in the range of 3.1120 angstroms or more to 3.1150 angstroms or less, and lattice constants in the c-axis direction in the range of 4.9800 angstroms or more to 4.9850 angstroms or less.

It was also found that the aluminum nitride single crystals manufactured by the manufacturing methods of Examples 1 to 3 have volume resistivities at 500°C are 5×10⁻⁸ Ω cm or more.

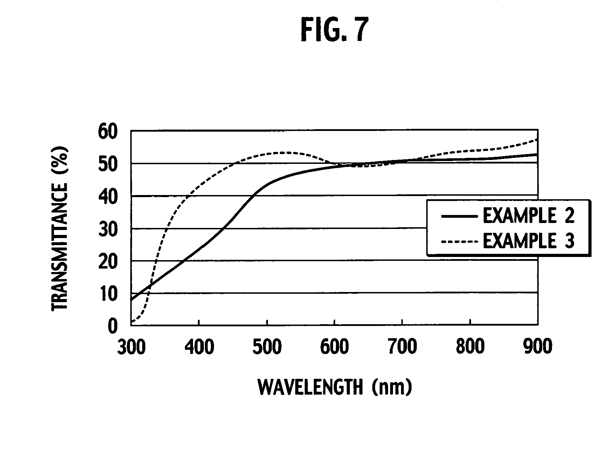

Light transmittance of the aluminum nitride single crystals manufactured by the manufacturing methods of Examples 2 and 3 was evaluated. As a result, it was found that, in the aluminum nitride single crystals manufactured by the manufacturing method of Examples 2 and 3, a transmittance of light having a wavelength of 400 nm or more is 40% or more, as shown in Fig. 7.

Color of the aluminum nitride single crystals manufactured by the manufacturing methods of Examples 1 to 3 was evaluated. As a result, it was found that the color tone of the aluminum nitride single crystals manufactured by the manufacturing method of Examples 1 to 3 are any one of colorless, yellow, or blue.

The aluminum nitride single crystals manufactured by the manufacturing methods of Examples 1 to 3 were evaluated for a density of etch pits, which were manufactured by etching the c-plane by a 45 wt% aqueous KOH solution at a temperature of 60°C for 20 minutes. As a result, the density of etch pits was found to be 10⁴ cm⁻² or less.

Generally, when oxygen forms a solid solution in an aluminum nitride single crystal, the volume resistivity decreases, the color tone turns black, and transmittance decreases. However, when both carbon and oxygen form solid solutions as is in the aluminum nitride single crystals of Examples 1 to 3, a high volume resistivity can be maintained up to a high temperature. It is therefore expected that these single crystals may be applied to devices and substrates used stably up to a high temperature. In particular, when the ratio of the oxygen amount (Xo) (mol%) to the carbon amount (Xc) (mol%) present in the form of solid solution, that is, Xo/Xc, falls within the range of 0.6 to 1.4, a stable volume resistivity value can be obtained due to electric charge compensation. Furthermore, since the transmittance is high, it is expected that these single crystals may be applied to devices and substrates for optical use.

In the aluminum nitride manufactured by a general sublimation method or the like, impurity level is formed of oxygen or the like, inevitably present as a solid solution. When the impurity level is formed, a volume resistivity decreases. In addition, light absorption corresponding to the impurity level occurs, light transmittance decreases. In contrast, counter-doping of carbon in addition to oxygen inevitably doped as an impurity conceivably prevented formation of the impurity level, resulting in suppressing reduction in the volume resistivity and the transmittance. Accordingly, it is desirable that the ratio of oxygen content (Xo) (mol%) to carbon content (Xc) (mol%), that is, Xo/Xc, preferably falls within the range of 0.6 or more to 1.4 or less; Xo/Xc more preferably falls within the range of 0.7 or more to 1.3 or less; Xo/Xc more preferably falls within the range of 0.8 or more to 1.2 or less; Xo/Xc more preferably falls within the range of 0.9 or more to 1.1 or less; and Xo/Xc is still more preferably 1.

While reduction in the volume resistivity and the transmittance can be suppressed by simultaneously forming solid solutions of oxygen and carbon, when the total amount of solid solutions increases, the thermal conductivity may decrease. For this reason, it is desirable that the amount of carbon falls within the range of 0.10 wt% or more to 1.0 wt% or less and the amount of oxygen falls within the range of 0.10 wt% or more to 1.0 wt% or less; more preferably that the amount of carbon falls within the range of 0.10 wt% or more to 0.77 wt% or less and the amount of oxygen falls within the range of 0.10 wt% or more to 0.82 wt% or less; more preferably that the amount of carbon falls within the range of 0.10 wt% or more to 0.37 wt% or less and the amount of oxygen falls within the range of 0.10 wt% or more to 0.38 wt% or less; and more preferably that the amount of carbon falls within the range of 0.10 wt% or more to 0.18 wt% or less and the amount of oxygen falls within the range of 0.10 wt% or more to 0.21 wt% or less.

Furthermore, lattice constant has a correlation with a solid solution amount of impurities. In view of maintaining a thermal conductivity, it is desirable that the lattice constant in the a-axis direction falls within the range of 3.1120 angstroms or more to 3.1150 angstroms or less and the lattice constant in the c-axis direction falls within the range of 4.9800 angstroms or more to 4.9850 angstroms or less; more preferably that the lattice constant in the a-axis direction falls within the range of 3.1120 angstroms or more to 3.1139 angstroms or less and the lattice constant in the c-axis direction falls within the range of 4.9800 angstroms or more to 4.9839 angstroms or less; and more preferably that the lattice constant in the a-axis direction falls within the range of 3.1120 angstroms or more to 3.1126 angstroms or less and the lattice constant in the c-axis direction falls within the range of 4.9800 angstroms or more to 4.9827 angstroms or less.

## Claims

1. A manufacturing method of an aluminum nitride single crystal, wherein the aluminum nitride single crystal is manufactured by growing a crystal of aluminum nitride on a surface of a crystal growth substrate (10) whose exposed surface has an inclination of 90° relative to a {0001} plane.

2. The manufacturing method of an aluminum nitride single crystal according to claim 1, wherein the exposed surface of the crystal growth substrate (10) is a {10-10} plane.

3. The manufacturing method of an aluminum nitride single crystal according to claim 1 or 2, wherein the crystal of aluminum nitride is grown under a manufacturing condition that a ratio of a growth rate of aluminum nitride in an a-axis direction to that in a c-axis direction is 1 or more.

4. Themanufacturingmethodof analuminumnitride single crystal according to any one of claims 1-3, wherein the aluminum nitride single crystal is grown under a manufacturing condition that a growth rate of aluminum nitride in the a-axis direction is 100 µm or more to 2000 µm or less.

5. Themanufacturingmethodof an aluminum nitride single crystal according to any one of claims 1-4, wherein the crystal growth substrate (10) is formed of a rod-shape single crystal whose length direction is oriented to the c-axis direction and the exposed surface of the crystal growth substrate is formed in the side portion of the single crystal.

6. The manufacturing method of an aluminum nitride single crystal according to any one of claims 1-5, wherein the crystal growth substrate (10) is comprised of aluminum nitride.

7. Themanufacturingmethodof an aluminum nitride single crystal according to any one of claims 1-6, wherein the aluminum nitride is grown into a crystal by a gas phase method.

8. Themanufacturingmethodof analuminumnitride single crystal according to any one of claims 1-7, wherein the aluminum nitride is grown into a crystal by a vapor phase method using a compound or a mixture constituted of Al, O, and N as a raw material.

9. Themanufacturingmethodof analuminumnitride single crystal according to any one of claims 1-8, wherein the aluminum nitride is grown into a crystal on not less than two exposed surfaces of the crystal growth substrate (10) each having an inclination of 90° relative to the {0001} plane.

10. Themanufacturingmethodof analuminumnitride single crystal according to claim 9, wherein the aluminum nitride is grown into a crystal on six exposed surfaces of the crystal growth substrate (10) each having an inclination of 90° relative to the {0001} plane.

11. An aluminum nitride single crystal manufactured by the method according to any one of claims 1-10, wherein the density of etch pits, which are produced by etching the c-plane by a 45 wt% aqueous KOH solution at a temperature of 60°C for 20 minutes, is 10⁴ cm⁻² or less.

12. An aluminum nitride single crystal, wherein carbon is contained within the range of 0.10 wt% or more to 1.0 wt% or less and oxygen is contained within the range of 0.10 wt% or more to 1.0 wt% or less.

13. The aluminum nitride single crystal according to claim 12, wherein a ratio of the oxygen content (Xo) (mol%) relative to the carbon content (Xc) (mol%), that is, Xo/Xc, falls within the range of 0.6 or more to 1.4 or less.

14. The aluminum nitride single crystal according to claims 12 or 13, wherein lattice constant in the a-axis direction falls within 3.1120 angstroms or more to 3.1150 angstroms or less and lattice constant in the c-axis direction falls within 4.9800 angstroms or more to 4.9850 angstroms or less.

15. An aluminum nitride single crystal, wherein a volume resistivity at 500°C is 5×10⁻⁸ Ω cm or more.

16. An aluminum nitride single crystal, wherein a transmittance of light having a wavelength of 400 nm or more is 40% or more.

17. The aluminum nitride single crystal according to claim 16, wherein color tone is any one of colorless, yellow, and blue.

18. The aluminum nitride single crystal according to claim 12, wherein the density of etch pits, which are produced by etching the c-plane by a 45 wt% aqueous KOH solution at a temperature of 60°C for 20 minutes, is 10⁴ cm⁻² or less.
